# EUROPÄISCHE PATENTANMELDUNG

(11) **EP 3 654 740 A1**
(43) Veröffentlichungstag der Anmeldung: **20.05.2020**
(21) Anmeldenummer: 18207072.2
(22) Anmeldetag: 19.11.2018
(51) Int. Cl.: H05K 3/34, H05K 1/02, H05K 1/18, H05K 1/11

(54) **SCHALTUNGSVORRICHTUNG ZUR THERMISCHEN ÜBERWACHUNG EINES BAUTEILS**

(71) Anmelder: BorgWarner, Inc., Auburn Hills, MI 48326-2872 (US)
(72) Erfinder: Glaß, Thomas, 67806 Rockenhausen (DE); Bräuchle, Gerd, 74928 Hüffenhardt (DE)
(74) Vertreter: Baur & Weber Patentanwälte PartG mbB

(57) **Zusammenfassung**

Es wird eine Schaltungsvorrichtung zur thermischen Überwachung eines Bauteils (16), insbesondere in einer Aufladevorrichtung (1) für eine Brennkraftmaschine, beschrieben, wobei auf einer ersten Seite (20) einer Leiterplatte (18) das Bauteil (16) angeordnet ist und benachbart zum Bauteil (16) ein Temperaturmessgeber (17) angeordnet ist, wobei der Temperaturmessgeber (17) über eine die Leiterplatte (18) von der ersten Seite (20) wenigstens teilweise durchdringende Durchkontaktierung (22) thermisch an das Bauteil (16) angebunden ist.

## Beschreibung

Die Erfindung betrifft eine Schaltungsvorrichtung zur thermischen Überwachung eines Bauteils, insbesondere in einer Aufladevorrichtung für eine Brennkraftmaschine.

Aus dem allgemeinen Stand der Technik sind Aufladevorrichtungen in Form von Abgasturboladern bekannt, bei denen ein Turbinenrad ein Verdichterrad eines Verdichters antreibt. Turbinenrad und Verdichterrad sind auf einem gemeinsamen Rotor angeordnet, der in einem Lagergehäuse drehbar geführt ist. Das Turbinenrad wird von einem Abgasstrom angetrieben. Der Verdichter ist im Ansaugtrakt einer Brennkraftmaschine angeordnet.

Desweiteren sind Aufladevorrichtungen bekannt, bei denen der Antrieb des Verdichterrads nicht mittels des Turbinenrads sondern mittels eines Elektromotors erfolgt.

Eine derartige Vorrichtung ist beispielsweise aus der EP 2 952 758 A2 bekannt. Die darin beschriebene Aufladevorrichtung für eine Brennkraftmaschine, insbesondere für ein Fahrzeug, umfasst einen Verdichter mit einem Verdichtergehäuse und ein in einem Verdichterraum angeordnetes Verdichterrad, einen Elektromotor mit einem Rotor und einem Stator, ein Motorgehäuse mit einem Motorraum zur Aufnahme des Rotors und des Stators und eine Verbindung von dem Verdichterraum in den Motorraum, um einen Druckausgleich zwischen dem Verdichterraum und dem Motorraum zu ermöglichen.

Bei beiden Ausführungen müssen oftmals auch elektrische Baugruppen mit einer Temperaturüberwachung einzelner Bauteile versehen werden, die zwar einerseits wenig zusätzlichen Platzbedarf erfordern aber andererseits dennoch genaue Ergebnisse liefern soll.

In der EP 2 525 632 A1 wird ein Wärmeabfuhrsystem für eine Leiterplattenbaugruppe beschrieben. Das Wärmeabfuhrsystem umfasst eine gedruckte Leiterplatte (PCB), mindestens ein thermisches Durchkontaktierungsloch, das sich durch die Leiterplatte erstreckt, und ein thermisches Schnittstellenmaterial (TIM), das mit dem mindestens einen thermischen Durchkontaktierungsloch gekoppelt ist, so dass der Leiterplatte durch das mindestens eine thermische Durchkontaktierungsloch und das thermische Schnittstellenmaterial Wärme entzogen wird.

Die US 2013/0126215 A1 bezieht sich auf eine gedruckte Leiterplatte. Die gedruckte Leiterplatte beinhaltet ein Substrat; ein auf einer Oberfläche des Substrats gebildetes Schaltungsmuster; ein auf der Oberfläche des Substrats gebildetes Blindmuster, wobei das Schaltungsmuster nicht gebildet wird, um ein vorgegebenes Intervall vom Schaltungsmuster beabstandet zu sein; und eine Vielzahl von wärmeabstrahlenden Durchkontaktierungen, die entlang eines äußeren Randes des Substrats gebildet werden, um die Blindmuster durch das Substrat elektrisch zu verbinden, und es ist möglich, die Erzeugung von elektromagnetischen Wellen zu unterdrücken oder die elektromagnetischen Wellen abzuschirmen und gleichzeitig die Wärmeabstrahlungseigenschaften zu verbessern.

Ausgehend von diesem Stand der Technik ist es nun Aufgabe der Erfindung, einen Temperaturmessgeber zu schaffen, der wenig zusätzlichen Platz benötigt aber dennoch eine gute thermische Anbindung an die zu überwachende Stelle aufweist, so dass eine kostengünstige Montage an oder in einer Aufladevorrichtung für eine Brennkraftmaschine möglich ist.

Diese Aufgabe wird durch den unabhängigen Patentanspruch 1 gelöst. Weitere vorteilhafte Ausgestaltungen der Erfindung sind jeweils Gegenstand der Unteransprüche. Diese können in technologisch sinnvoller Weise miteinander kombiniert werden. Die Beschreibung, insbesondere im Zusammenhang mit der Zeichnung, charakterisiert und spezifiziert die Erfindung zusätzlich.

Gemäß der Erfindung wird eine Schaltungsvorrichtung zur thermischen Überwachung eines Bauteils, insbesondere in einer Aufladevorrichtung für eine Brennkraftmaschine, geschaffen, wobei auf einer ersten Seite einer Leiterplatte das Bauteil angeordnet und benachbart zum Bauteil ein Temperaturmessgeber angeordnet ist, wobei der Temperaturmessgeber über eine die Leiterplatte von der ersten Seite wenigstens teilweise durchdringende Durchkontaktierung thermisch an das Bauteil angebunden ist.

Demnach wird eine Schaltungsvorrichtung geschaffen, bei der die thermische Ankopplung des Temperaturmessgebers im Vergleich zu anderen bekannten Anordnungen deutlich verbessert ist. Aufgrund der besseren thermischen Ankopplung ist es möglich, das zu überwachende Bauteil bezüglich seiner Betriebszustände näher an das thermische Limit zu führen, da wegen der schnelleren Reaktion durch den Temperaturmessgeber eine schnellere Reaktion durch die Schaltungsvorrichtung erreicht werden kann, so dass ihr dynamisches Verhalten ebenfalls verbessert ist. Dadurch, dass die Messstelle unmittelbar benachbart zum Bauteil gewählt wird, ist eine präzise Bestimmung der aktuellen Temperatur möglich, wobei die vom Bauteil abgegeben Wärme an der Durchkontaktierung aufgenommen und weitergeleitet wird. Folglich wird das dynamische Verhalten des Temperaturmessgebers verbessert, ohne dass dieser durch andere Einflüsse, die beispielsweise durch Signaleinkopplung von anderen Bauteilen entstehen können, beeinflusst wird. Auf diese Weise ist es möglich, bezüglich ihrer Leistung kleiner bemessene Bauteile zu wählen, da der thermische Grenzfall besser und frühzeitiger ermittelt werden kann. Erfindungsgemäß können diese daher näher am Limit betrieben werden, wodurch Kosten eingespart werden können, da keine oder lediglich eine geringere Überdimensionierung der Bauteile zur Bereitstellung einer Sicherheitsmarge vorgenommen werden muss. Dadurch ist gegebenenfalls auch eine Platzersparnis bei der Bereitstellung einer entsprechenden Schaltungsvorrichtung möglich.

Gemäß einer Ausführungsform der Erfindung ist der Temperaturmessgeber auf der ersten Seite der Leiterplatte angeordnet. In einer alternativen Ausführungsform der Erfindung kann der Temperaturmessgeber auch auf einer zur ersten Seite gegenüberliegenden zweiten Seite der Leiterplatte angeordnet sein.

Die Durchkontaktierung verbessert die thermische Ankopplung des Temperaturmessgebers an das zu überwachende Bauteil, wobei dies sowohl für eine Anordnung von Temperaturmessgeber und Bauteil auf der gleichen Seite als auch auf gegenüberliegenden Seiten der Leiterplatte realisierbar ist. Die Durchkontaktierung nimmt die vom Bauteil abgegebene Wärme auf und transportier diese zum Temperaturmessgeber.

Gemäß einer Ausführungsform der Erfindung durchdringt die Durchkontaktierung die Leiterplatte vollständig.

Die Platzierung des Temperaturmessgebers unmittelbar benachbart zum Bauteil auf der anderen Seite der Leiterplatte verbessert die thermische Ankopplung mittels der Durchkontaktierung weiter. Eine Durchkontaktierung in einem Sackloch, das die Leiterplatte nicht vollständig durchdringt, wäre ebenso möglich.

Gemäß einer weiteren Ausführungsform der Erfindung ist die Leiterplatte mehrlagig ausgeführt. Dabei kann die Durchkontaktierung auf einer oder mehreren Innenlagen der Leiterplatte mit Metallflächen verbunden sein, um die thermischen Anbindung an das Bauteil zu erhöhen. Vorteilhafterweise sind die Metallflächen elektrisch isoliert auf dieser Innenlage ausgeführt. Des Weiteren können die Metallflächen auf benachbarten Innenlagen fächerförmig angeordnet sein.

Diese Ausführungen erhöhen jeweils die thermische Anbindung an das Bauteil, so dass die dynamische Reaktion der erfindungsgemäßen Schaltungsvorrichtung verbessert wird. Die wird insbesondere durch eine Vergrößerung der Fläche zur thermischen Anbindung erreicht.

Gemäß einer weiteren Ausführungsform der Erfindung sind das Bauteil und/oder der Temperaturmessgeber als Oberflächen-montierte Baugruppe gebildet.

Aufgrund dieser Vorgehensweise ist ein platzsparender Aufbau der erfindungsgemäßen Schaltungsvorrichtung möglich.

Gemäß einer weiteren Ausführungsform der Erfindung ist Bauteil ein Leistungstransistor, der vorzugsweise zur Ansteuerung eines Elektromotors vorgesehen ist.

Bei einer Aufladevorrichtung mit einem durch einen Elektromotor angetriebenen Verdichter werden oftmals dreiphasige Brückenschaltungen zur Ansteuerung verwendet, deren Leistungsstufen Transistoren aufweisen. Einer oder mehrerer dieser Transistoren können mit der erfindungsgemäßen Schaltungsvorrichtung bezüglich ihrer Temperatur überwacht werden.

Gemäß einer weiteren Ausführungsform der Erfindung ist der Temperaturmessgeber als Widerstand mit negativen Temperaturkoeffizienten ausgeführt.

Derartige Widerstände werden oftmals als Temperaturmessgeber eingesetzt, so dass die erfindungsgemäße Schaltungsvorrichtung kostengünstig realisierbar ist.

In einem weiteren Aspekt wird eine Aufladevorrichtung für eine Brennkraftmaschine, insbesondere in einem Fahrzeug, beschrieben wobei die Aufladevorrichtung einen Verdichter mit einem Verdichtergehäuse und einem Verdichterraum, in dem ein Verdichterrad angeordnet ist, einen Elektromotor mit einem Motorgehäuse, eine Leistungselektronikschaltung zur Ansteuerung des Elektromotors, die in einem Aufnahmeraum benachbart zum Motorgehäuse angeordnet ist, aufweist, wobei zur thermischen Überwachung eine Schaltungsvorrichtung wie oben beschrieben vorgesehen ist.

Die Schaltungsvorrichtung kann innerhalb der Leistungselektronikschaltung angeordnet ist. Alternativ oder zusätzlich kann die Schaltungsvorrichtung an dem Elektromotor angeordnet sein.

Nachfolgend werden einige Ausführungsbeispiele anhand der Zeichnung näher erläutert. Es zeigen:
- Fig. 1: eine Aufladevorrichtung für eine Brennkraftmaschine in einer Schnittdarstellung,
- Fig. 2: eine Schaltungsvorrichtung gemäß der Erfindung in einer Schnittansicht,
- Fig. 3: eine Schaltungsvorrichtung gemäß der Erfindung in einer Draufsicht.

In den Figuren sind gleiche oder funktional gleich wirkende Bauteile mit den gleichen Bezugszeichen versehen.

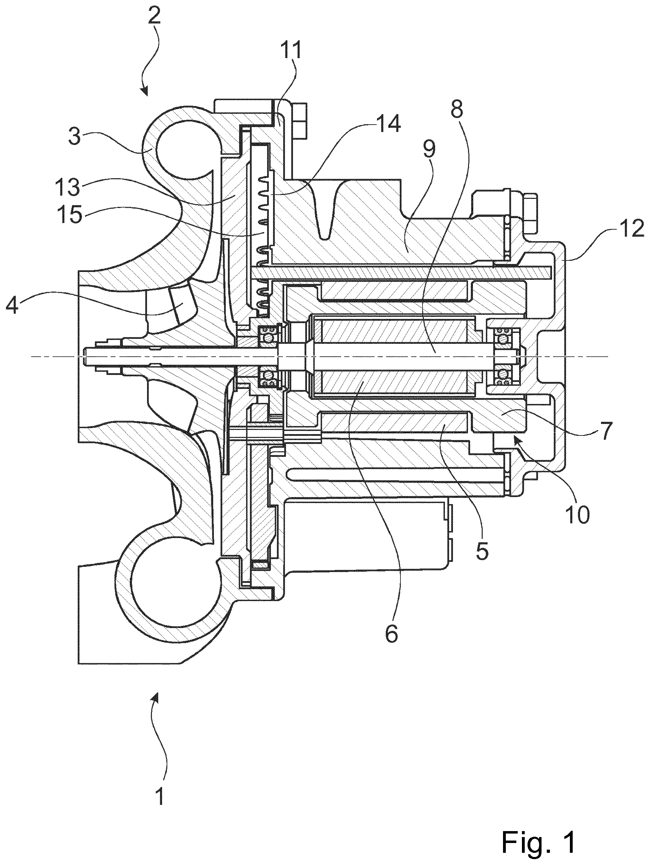

Im Folgenden wird anhand der Fig. 1 eine Aufladevorrichtung 1 gemäß einem Ausführungsbeispiel im Detail beschrieben, in welcher die erfindungsgemäße Schaltungsvorrichtung bevorzugt eingesetzt werden kann.

Figur 1 zeigt in Schnittansicht die Aufladevorrichtung 1 umfassend einen Verdichter 2. Der Verdichter 2 weist ein Verdichtergehäuse 3 auf. In dem Verdichtergehäuse 3 ist ein Verdichterrad 4 angeordnet. Dieses Verdichterrad 4 befindet sich im sogenannten Verdichterraum. Des Weiteren umfasst die Aufladevorrichtung 1 einen Elektromotor 5. Der Elektromotor 5 setzt sich zusammen aus einem Rotor 6 und einem Stator 7. Über eine Welle 8 ist der Rotor 6 drehfest mit dem Verdichterrad 4 verbunden. Durch Rotation des Elektromotors 5 wird somit auch das Verdichterrad 4 in Rotation versetzt. Das Verdichterrad 4 und der Rotor 6 sind koaxial angeordnet, sodass die Welle 8 gleichzeitig auch die Rotorwelle ist.

Rotation des Elektromotors 5 und somit bei Rotation des Verdichterrades 4 wird Luft in Axialrichtung angesaugt. Über den Verdichter 2 wird die Luft in Radialrichtung verdichtet und einer Brennkraftmaschine zugeführt.

Die Aufladevorrichtung 1 umfasst ferner ein Motorgehäuse 9. In diesem Motorgehäuse 9 ist ein Motorraum 10 ausgebildet. Der Motorraum 10 ist auf der dem Verdichter 2 abgewandten Seite mittels eines Deckels 12 verschlossen. Zum Verdichter 2 hin ist der Motorraum 10 durch eine Wand 11 des Motorgehäuses 9 begrenzt. Das Verdichtergehäuse 3 ist auf seiner dem Motorgehäuse 9 zugewandten Seite offen. Diese offene Seite ist mittels einer Rückwand 13 verschlossen. An der Rückwand 13 können an einer dem Verdichter 2 zugewandten Seite nicht gezeigte Mittel vorgesehen sein, welche eine definierte axiale Positionierung der Rückwand 13 relativ zum Verdichtergehäuse bereitstellen.

Das Motorgehäuse 9 ist mit seiner Wand 11 fest mit dem Verdichtergehäuse 3 verbunden, insbesondere verschraubt. Dabei ist zwischen der Rückwand 13 und der Wand 11 ein Aufnahmeraum 14 ausgebildet. In diesem Aufnahmeraum 14 befindet sich eine Leistungselektronikschaltung 15 zur Stromversorgung und Ansteuerung des Elektromotors 5. Der Aufnahmeraum 14 ist gegenüber dem Verdichterraum und gegenüber dem Motorraum 10 hermetisch abgedichtet.

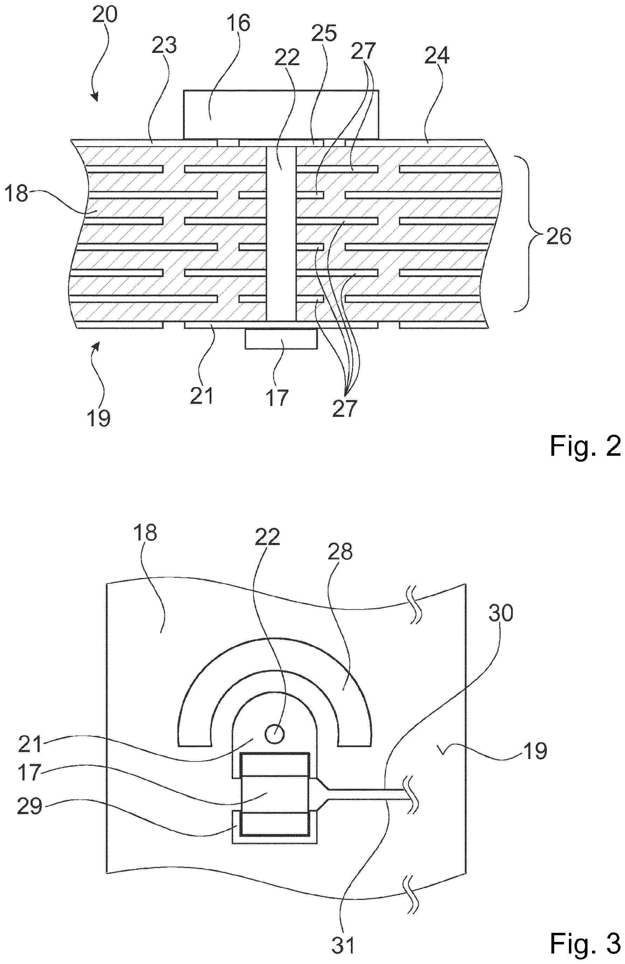

Die Temperaturüberwachung eines Bauteils wird nachfolgend unter Bezugnahme auf Fig. 2 näher erläutert. Beispielhaft wird hier die Temperaturüberwachung eines Transistors 16 beschrieben, der Teil der Leistungselektronikschaltung 15 sein kann. Allgemein können sämtliche als Wärmequelle dienende Bauteile erfindungsgemäß überwacht werden. Die Leistungselektronikschaltung 15 kann einen Transistor 16 aufweisen, der beispielsweise zur Ansteuerung des Elektromotors 5 einzeln oder in Kombination mit anderen Transistoren ausgebildet ist.

Wie in Fig. 2 gezeigt ist, kann der Transistor 16 zusammen mit einem Temperaturmessgeber 17 auf einer Leiterplatte 18 angeordnet sein. Dabei ist der Temperaturmessgeber 17 auf einer zweiten Seite 19 und der Transistor 16 auf einer ersten Seite 20 gegenüberliegend auf der Leiterplatte 18 angeordnet. Eine Anordnung, bei der der Temperaturmessgeber 17 und der Transistor 16 auf einer Seite 20 der Leiterplatte 18 nebeneinanderliegend angeordnet sind, ist ebenfalls möglich.

Die zweite Seite 19 der Leiterplatte 18 ist mit einer Anschlussfläche 21 versehen, die in eine Durchkontaktierung 22 mündet, die die zweite Seite 19 mit der ersten Seite 20 verbindet. Gegenüberliegend zur Anschlussfläche 21 befindet sich der Transistor 16, der mittels weiterer Anschlussflächen 23 und 24 beispielhaft mit anderen Komponenten der Leistungselektronikschaltung verbunden werden kann.

Der Temperaturmessgeber 17 ist somit über die Durchkontaktierung 22 und der gegenüberliegenden nicht mit weiteren Schaltungskomponenten verbundenen Ankoppelfläche 25 verbunden. Somit entsteht ein Wärmeübertrag von der Ankoppelfläche 25 über die Durchkontaktierung 22 in die Anschlussfläche 21, die wiederum mit dem Temperaturmessgeber 17 in Verbindung steht.

Die Leiterplatte 18 kann insbesondere als mehrlagige Leiterplatte ausgeführt sein, was in Fig. 2 mittels der Innenlagen 26 angedeutet ist. Auf den Innenlagen 26 sind Metallflächen, in Fig. 2 schematisch mit den Bezugszeichen 27 versehen, ausgebildet, um die Ankopplung zwischen Transistor 16 und Temperaturmessgeber 17 weiter zu verbessern. Die Metallflächen 27 auf den Innenlagen 26 sind funktionslos und würden in konventionellen Anwendungen weggeätzt werden. Somit ist kein zusätzlicher Aufwand nötig. Das verschränkte oder überlappende Ausgestaltung der Metallflächen 27 auf den Innenlagen 26 begünstigt die thermische Ankopplung bei gleichzeitig galvanischer Trennung. Diese Ausgestaltung der Metallflächen 27 kann auch als fächerförmig bezeichnet werden.

Neben einer vollständig die Leiterplatte 18 durchdringenden Durchkontaktierung 22, wie sie in Fig. 2 zwischen der Ankoppelfläche 25 und der Anschlussfläche 21 gezeigt ist, kann auch in einer alternativen Ausführungsform eine die Leiterplatte 18 nur von der Anschlussfläche 21 bis zu einer Innenlage 26 durchdringenden Durchkontaktierung verwendet werden.

In Fig. 3 ist die Schaltungsvorrichtung nochmals in einer Draufsicht auf die zweite Seite 19 gezeigt. Die Anschlussfläche 21 kann beispielsweise mittels einer weiteren Leiterbahn 28 elektrisch von weiteren Signalleitungen isoliert werden, um störende Einflüsse durch Signale auf der Leiterplatte zu verhindern. Desweiteren erkennt man in Fig. 3, dass der Temperaturmessgeber 17 mit seiner ersten Kontaktfläche mit der Anschlussfläche 21 verbunden ist und mit einer zweiten Kontaktfläche mit einem Lötpad 29. Die Anschlussfläche 21 und das Lötpad 29 münden jeweils in eine Anschlussleitung 30 bzw. 31, so dass der Temperaturmessgeber 17 mit weiteren Komponenten verbunden werden kann, um ein entsprechendes Signal abzuleiten, das bei kritischen Temperaturbedingungen des Bauteils entsprechende Maßnahmen einleitet.

Der Temperaturmessgeber 17 wird bevorzugt als NTC-Widerstand ausgebildet, wobei andere Möglichkeiten hier nicht ausgeschlossen sein sollen. Ein NTC-Widerstand weist einen negativen Temperaturkoeffizienten auf und wird oftmals als Temperaturmessgeber eingesetzt. Der Transistor 16 kann Bestandteil einer dreiphasigen Brückenschaltung zur Ansteuerung des Elektromotors 5 sein, wobei in anderen Ausführungsformen auch weitere Komponenten der Leistungselektronikschaltung 15 alternativ oder zusätzlich mit einer erfindungsgemäßen Schaltungsvorrichtung versehen werden.

Neben der Verwendung in einer Aufladevorrichtung mit einem Elektromotor als Verdichter kann die erfindungsgemäße Schaltungsvorrichtung auch bei anderen, mittels durch Abgasströme angetrieben Turbinenräder eingesetzt werden, die mit einem Verdichter auf konventionelle Weise auf einer gemeinsamen Welle montiert sind.

Die vorstehend und die in den Ansprüchen angegebenen sowie die den Abbildungen entnehmbaren Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens in mancherlei Weise abwandelbar.

### Liste der Bezugszeichen:

1 Aufladevorrichtung
2 Verdichter
3 Verdichtergehäuse
4 Verdichterrad
5 Elektromotor
6 Rotor
7 Stator
8 Welle
9 Motorgehäuse
10 Motorraum
11 Wand
12 Deckel
13 Rückwand
14 Aufnahmeraum
15 Leistungselektronikschaltung
16 Transistor
17 Temperaturmessgeber
18 Leiterplatte
20,19 erste Seite, zweite Seite
21 Anschlussfläche
22 Durchkontaktierung
23 Anschlussfläche
25 Ankoppelfläche
26 Innenlage
27 Metallfläche
28 Leiterbahn
29 Lötpad
30,31 Anschlussleitung, weitere Anschlussleitung

## Patentansprüche

1. Schaltungsvorrichtung zur thermischen Überwachung eines Bauteils (16), insbesondere in einer Aufladevorrichtung (1) für eine Brennkraftmaschine, wobei auf einer ersten Seite (20) einer Leiterplatte (18) das Bauteil (16) angeordnet ist und benachbart zum Bauteil (16) ein Temperaturmessgeber (17) angeordnet ist, wobei der Temperaturmessgeber (17) über eine die Leiterplatte (18) von der ersten Seite (20) wenigstens teilweise durchdringende Durchkontaktierung (22) thermisch an das Bauteil (16) angebunden ist.

2. Schaltungsvorrichtung nach Anspruch 1, bei der der Temperaturmessgeber (17) auf der ersten Seite (20) der Leiterplatte (18) angeordnet ist.

3. Schaltungsvorrichtung nach Anspruch 1, bei der der Temperaturmessgeber (17) auf einer zur ersten Seite (20) gegenüberliegenden zweiten Seite (19) der Leiterplatte (18) angeordnet ist.

4. Schaltungsvorrichtung nach einem der Ansprüche 1 bis 3, bei der die Durchkontaktierung (22) die Leiterplatte (18) vollständig zwischen der ersten Seite (20) und der zweiten Seite (19) durchdringt.

5. Schaltungsvorrichtung nach einem der Ansprüche 1 bis 4, bei der die Leiterplatte (18) mehrlagig ausgeführt ist.

6. Schaltungsvorrichtung nach Anspruch 5, bei der die Durchkontaktierung (22) auf einer oder mehreren Innenlagen (26) der Leiterplatte (18) mit Metallflächen (27) verbunden ist, um die thermischen Anbindung an das Bauteil (16) zu erhöhen.

7. Schaltungsvorrichtung nach Anspruch 5 oder 6, bei der die Metallflächen (27) elektrisch isoliert auf der Innenlage (26) ausgeführt sind.

8. Schaltungsvorrichtung nach einem der Ansprüche 5 bis 7, bei der die Metallflächen (27) auf benachbarten Innenlagen (26) fächerförmig angeordnet sind.

9. Schaltungsvorrichtung nach einem der Ansprüche 1 bis 8, bei der das Bauteil (16) und/oder der Temperaturmessgeber (17) als Oberflächen-montierte Baugruppe gebildet sind.

10. Schaltungsvorrichtung nach einem der Ansprüche 1 bis 9, bei der Bauteil (16) ein Leistungstransistor ist, der vorzugsweise zur Ansteuerung eines Elektromotors (5) vorgesehen ist.

11. Schaltungsvorrichtung nach einem der Ansprüche 1 bis 10, bei der der Temperaturmessgeber (17) als Widerstand mit negativen Temperaturkoeffizienten ausgeführt ist.

12. Aufladevorrichtung für eine Brennkraftmaschine, insbesondere in einem Fahrzeug, wobei die Aufladevorrichtung (1) aufweist:
- einen Verdichter (2) mit einem Verdichtergehäuse (3) und einem Verdichterraum, in dem ein Verdichterrad (4) angeordnet ist,
- einen Elektromotor (5) mit einem Motorgehäuse (9),
- eine Leistungselektronikschaltung (15) zur Ansteuerung des Elektromotors (5), die in einem Aufnahmeraum (14) benachbart zum Motorgehäuse (9) angeordnet ist, wobei zur thermischen Überwachung eine Schaltungsvorrichtung nach einem der Ansprüche 1 bis 11 vorgesehen ist.

13. Aufladevorrichtung nach Anspruch 12, bei der die Schaltungsvorrichtung innerhalb der Leistungselektronikschaltung (15) angeordnet ist.

14. Aufladevorrichtung nach Anspruch 12, bei der die Schaltungsvorrichtung an dem Elektromotor (5) angeordnet ist.
